# EUROPÄISCHE PATENTSCHRIFT

(11) **EP 2 786 646 B1**
(45) Veröffentlichungstag und Bekanntmachung des Hinweises auf die Patenterteilung: **25.01.2017**
(21) Anmeldenummer: 11801633.6
(22) Anmeldetag: 30.11.2011
(51) Int. Cl.: H02J 3/24, H02J 3/32, H02K 5/10, H05K 5/06

(54) **GEHÄUSE ZUR AUFNAHME EINER ELEKTRONIKSCHALTUNG**
HOUSING FOR ACCOMMODATING AN ELECTRONIC CIRCUIT
BOÎTIER DESTINÉ À RECEVOIR UNE CIRCUITERIE ÉLECTRONIQUE

(43) Veröffentlichungstag der Anmeldung: 08.10.2014
(73) Patentinhaber: EBM-Papst Mulfingen GmbH&CO. KG, 74673 Mulfingen (DE)
(72) Erfinder: SAUER, Thomas, 97980 Bad Mergentheim (DE); BEST, Dieter, 74653 Ingelfingen (DE); MATTER, Walter, 74238 Krautheim (DE); BERBERICH, Joachim, 74722 Buchen-Rinschheim (DE)
(74) Vertreter: Jostarndt Patentanwalts-AG
(86) Internationale Anmeldenummer: PCT/EP2011/071342
(87) Internationale Veröffentlichungsnummer: WO 2013/079102

(56) Entgegenhaltungen:
- EP-A1- 1 560 319
- DE-A1- 4 217 837
- DE-A1-102004 012 229
- DE-A1-102005 038 688

## Beschreibung

Die vorliegende Erfindung betrifft ein Gehäuse zur Aufnahme einer Elektronikschaltung aus mehreren Bauelementen, bestehend aus einer Trägerplatte und einem Gehäusedeckel, mit einer auf der Trägerplatte angeordneten umfangsgemäß geschlossenen Wandung und einem auf der Wandung angeordneten, der Trägerplatte gegenüberliegenden Abdeckteil.

Elektronische Baugruppen müssen allgemein vor Feuchtigkeit geschützt werden. Es ist deshalb bekannt, dass man z. B. eine Feuchtschutzlackierung auf eine Leiterplatte einer elektronischen Schaltung und auf die auf der Leiterplatte befestigten Bauteile aufträgt. Diese Methode ist aber nur für leichten Feuchtebeschlag geeignet.

Weiterhin ist es bekannt, dass die elektronischen Bauteile in einer Vergussmasse eingegossen sind, was aber Nachteile im Hinblick auf die auftretenden thermomechanischen Kräfte mit sich bringt, die auf die Bauteile einwirken und diese beschädigen können.

Weiterhin ist es bekannt, ein dichtes Gehäuse zu verwenden, das mit einer Druckausgleichsmembran, einer sogenannten Gare-Membran versehen ist. Hierbei besteht der Nachteil, dass ein Luftaustausch mit der Umgebung stattfindet und dadurch ein Eindringen von Feuchtigkeit ins Gehäuse möglich ist.

Weiterhin ist aus der europäischen Offenlegungsschrift EP 1 560 319 A1 ein kollektorloser, elektronisch kommutierter Gleichstrommotor mit einem Stator und einen den Stator von einer Seite her als Teil eines Motorgehäuses topfartig umschließenden Außenläufer bekannt. Weiterhin weist der Gleichstrommotor einen sich als weiterer Teil des Motorgehäuses auf der dem Außenläufer axial gegenüberliegenden Seite anschließenden, eine Steuerelektronik enthaltendes Elektronikgehäuse auf. Axial zwischen einem Wickelkopf des Stators und einer sich quer zu einer Läuferachse erstreckenden Bodenwandung des Elektronikgehäuses ist ein im Wesentlichen scheibenförmiger Wickelkopfschutz zur Abdichtung von Anschlussdurchführungen der Bodenwandung angeordnet. Der Wickelkopfschutz weist mindestens eine in Richtung des Wickelkopfes vorspringende Aufnahmetasche für einen magnetfeldempfindlichen Drehstellungssensor derart auf, dass der durch eine Durchführung der Bodenwandung mit der Steuerelektronik verbundene und in der in Richtung des Wickelkopfes geschlossenen Aufnahmetasche sitzende Drehstellungssensor zur Erfassung eines Magnetfeldes des Außenläufers hinreichend nah an diesen angeordnet ist. Der Wickelkopfschutz kann gemeinsam mit einer elektronikseitigen Abdeckscheibe in einem Arbeitsgang durch beidseitiges Kunststotf-Umspritzen der Bodenwandung gebildet sein.

Weiterhin ist aus der deutschen Offenlegungsschrift DE 10 2004 012 229 A1 ein elektronisches Gerät mit einem Gehäuse bekannt, in dessen Innenraum mindestens ein elektronisches Bauelement angeordnet ist. Eine Trennwand unterteilt den Innenraum in mindestens einen gegen die Umgebungsatmosphäre abgedichteten Nutz-Raumabschnitt, in dem die Bauelemente untergebracht sind, und in mindestens einen Druckausgleichs-Raumabschnitt, der über eine Belüftungsöffnung mit der Umgebungsatmosphäre verbunden ist. Die Trennwand ist zumindest abschnittsweise derart beweglich, dass über die Bewegung der Trennwand ein Druckausgleich zwischen dem Nutz-Raumabschnitt und dem Druckausgleichs-Raumabschnitt stattfindet.

Weiterhin ist aus der deutschen Offenlegungsschrift DE 10 2005 038 688 A1 ein Volumenausgleichselement für Elektronikgehäuse, insbesondere im Automobilbereich bekannt. Das Volumenausgleichselement ist als elastische, impermeable Membran ausgebildet.

Weiterhin ist aus der deutschen Offenlegungsschrift DE 4 217 837 A1 eine elektronische Schaltungseinrichtung bekannt, wobei die elektronische Schaltungseinrichtung einen im wesentlichen kastenförmigen Gehäuse-Hauptkörper enthält, um einen abgedichteten inneren Raum darin zu definieren. Weiterhin enthält die elektronische Schaltungseinrichtung eine elektronische Schaltungsplatine mit einer Vielzahl von elektronischen Komponenten darauf. Der Gehäuse-Hauptkörper umfasst einen Gehäusekörper und einen flachen, plattenartigen Deckel der in geeigneter Weise bezüglich dem Gehäusekörper positioniert ist, um den inneren Raum abzudichten. Ein Belüftungsloch ist in der Bodenwand des Gehäusekörpers gebildet, um das Innere des Gehäusekörpers mit einer Umgebungsatmosphäre in Verbindung zu bringen. Ein Abdeckelement ist an dem Gehäusekörper angebracht, um das Belüftungsloch hermetisch abzudecken. Durch Verwendung eines Abdeckelements ist der innere Raum des Gehäusekörpers abgedichtet, um elektronische Komponenten auf der elektronischen Schaltungsplatine vor Feuchtigkeit und Regenwasser zu schützen und um eine Druckschwankung darin zu absorbieren.

Der vorliegenden Erfindung liegt die Aufgabe zu Grunde, die vorstehenden Nachteile zu beseitigen und ein Gehäuse für elektronische Bauteile zur Verfügung zu stellen, das einen verbesserten Feuchtigkeitsschutz der Bauteile gewährleistet, und zwar auch bei großen Temperaturschwankungen der Umgebungstemperatur insbesondere von - 40 ° C bis + 60 ° C.

Erfindungsgemäß wird dies dadurch erreicht, dass auf der Trägerplatte in einem vom Gehäusedeckel gegenüber einer äußeren Atmosphäre bzw. Umgebung druckdicht umschlossenen Innenraum ein Volumenausgleichselement befestigt und derart elastisch ausgebildet ist, dass zum Ausgleich von im Innenraum auftretenden Druckschwankungen ein veränderliches Raumvolumen durch eine Lageveränderung des Volumenausgleichselements in Bezug auf die Trägerplatte vorhanden ist sowie ein Zwischenraum zwischen dem Volumenausgleichselement und der Trägerplatte mit der äußeren Atmosphäre bzw. Umgebung verbunden ist. Erfindungsgemäß erfolgt der auf Grund von Temperaturschwankungen im Innenraum erforderliche Druckausgleich zwischen Innenraum und Außenraum, d. h. der äußeren Atmosphäre, durch einen Volumenausgleich und nicht durch einen Massenausgleich, wie beispielsweise bei der bekannten Druckausgleichsmembran. Durch die Erfindung werden auch die durch eine Eigenerwärmung des Motors auftretenden Temperatureinflüsse beherrscht. Hierbei ist es erfindungsgemäß insbesondere zweckmäßig, wenn der Bauraum, d. h. der Innenraum, zwischen dem Volumenausgleichselement und dem Gehäusedeckel derart dimensioniert ist, dass ein Volumenausgleich durch den Hub des Volumenausgleichelementes zwischen 20 % und 35 % des Innenraumvolumens realisierbar ist, wobei insbesondere das vorhandene Luftvolumen so gering wie möglich gehalten ist, indem ein hoher Füllgrad durch die elektronische Schaltung und eventuell weiterer vorhandener Volumenelemente erreicht wird. Erfindungsgemäß ist es vorteilhaft, wenn das Volumenausgleichselement in Form eines Einlegeteils befestigt wird, wobei das Volumenausgleichselement vorzugsweise scheibenförmig ausgebildet ist. Das Volumenausgleichselement besteht hierbei aus einem äußeren Befestigungsabschnitt und einem inneren Membranabschnitt, die über ein federelastisches Verbindungsteil umfänglich miteinander verbunden sind. Auf Grund dieser erfindungsgemäßen Ausgestaltung ist der äußere Befestigungsabschnitt zwischen dem Gehäusedeckel und der Trägerplatte eingespannt und der mittlere Membranabschnitt kann sich gegenüber dem eingespannten Befestigungsabschnitt membranartig bewegen.

Weiterhin ist es erfindungsgemäß vorteilhaft, wenn der Befestigungsabschnitt in seinem umfänglichen Randbereich ein Dichtprofil zum druckdichten Befestigen zwischen der Wandung und der Trägerplatte aufweist, so dass das Dichtprofil mit dem Volumenausgleichselement eine Montageeinheit bildet, da es an dem Befestigungsabschnitt beispielsweise angespritzt ist. Der Befestigungsabschnitt und der Membranabschnitt bestehen beispielsweise aus einem Hartkunststoff, wohingegen der elastische Verbindungsabschnitt aus einem federelastisch wirkenden Kunststoff besteht sowie das randseitige Dichtprofil aus einem Weichkunststoff, der üblicherweise für die Herstellung von Dichtungen, beispielsweise O-Dicht-Ringen verwendet wird. Vorteilhafterweise liegt der Befestigungsabschnitt des Volumenausgleichselements in paralleler Ausrichtung zur Trägerplatte auf dieser auf. Um eine ausreichende Auslenkung (Hub) des Membranabschnittes gegenüber dem Befestigungsabschnitt in Richtung auf den Statorflansch zu ermöglichen, wodurch sich eine Volumenvergrößerung des Innenraums ergibt, weist die Trägerplatte im Bereich unterhalb des Membranabschnittes eine Vertiefung auf, in der der Membranabschnitt form- und volumenmäßig aufgenommen werden kann. Weiterhin kann es zweckmäßig sein, wenn bei einer Bewegung des Membranabschnittes in Richtung der Leiterplatte der Hubweg begrenzt wird, was vorteilhafterweise durch auf dem Membranabschnitt ausgebildete Anschläge erreicht wird.

Da erfindungsgemäß nur ein sehr kleines Luftvolumen innerhalb des Innenraums vorhanden ist, wird in diesem Luftvolumen auch nur eine minimale Menge von Feuchtigkeit eingeschlossen. Hierdurch kann die Menge an Feuchtigkeit, die maximal in dem Luftvolumen vorhanden sein kann, zu keiner Schädigung der elektronischen Bauteile führen. Um das Luftvolumen innerhalb des Innenraums möglichst klein zu halten, ist es erfindungsgemäß weiterhin zweckmäßig, wenn auf der der Leiterplatte zugekehrten Seite des Volumenausgleichselements im Randbereich der Leiterplatte, d. h. zwischen der Wandung des Gehäuses und den elektronischen Bauelementen Volumenelemente vorgesehen sind. Es ist erfindungsgemäß auch optional möglich, zur Luftmengenreduzierung ein Einlegeteil oberhalb der Leiterplatte im Zwischenraum zwischen der Leiterplatte und dem Gehäusedeckel vorzusehen. Auf Grund der erfindungsgemäßen Ausgestaltung kann über einen Volumenausgleich keine weitere Feuchtigkeit in den Innenraum des Gehäuses zwischen dem Volumenausgleichselement und dem Gehäusedeckel eindringen, wodurch es nicht zur Akkumulation von Feuchtigkeit kommen kann, da kein Massentransport in das Gehäuse erfolgen kann. Weiterhin sorgt der erfindungsgemäße Druckausgleich für eine Entspannung an den vorhandenen Dichtelementen, da sich Innen- und Außendruck an den vorhandenen Dichtelementen annähernd angleichen. Eine vollständige Abdichtung gegen die äußere Umgebung, d. h. Atmosphäre, ist auch im Bereich von Durchführungen durch das erfindungsgemäße Volumenausgleichselement vorgesehen, die beispielsweise zum Durchführen von Anschlussstiften oder dergleichen dienen.

Vorteilhafte Ausführungsformen der Erfindung sind in den Unteransprüchen enthalten und werden an Hand der beiliegenden Zeichnungen näher erläutert.

Es zeigen:
- Fig. 1: eine Explosionsansicht eines Elektromotors mit einem erfindungsgemäßen Gehäuse,
- Fig. 2: einen Längsschnitt durch den Elektromotor gemäß Fig. 1 im montierten Zustand,
- Fig. 3: einen vergrößerten Teil-Ausschnitt gemäß III-III in Fig. 2,
- Fig. 4: eine Ansicht auf einen Stator des Elektromotors gemäß Fig. 1 mit einem aufgesetzten erfindungsgemäßen Volumenausgleichselement,
- Fig. 5: eine Ansicht auf eine Oberseite des erfindungsgemäßen Volumenausgleichselementes gemäß Fig. 4,
- Fig. 6: eine Ansicht auf eine Unterseite des Volumenausgleichselementes gemäß Fig. 5,
- Fig. 7: eine perspektivische Ansicht auf den Stator gemäß Fig. 4 ohne Volumenausgleichselement.

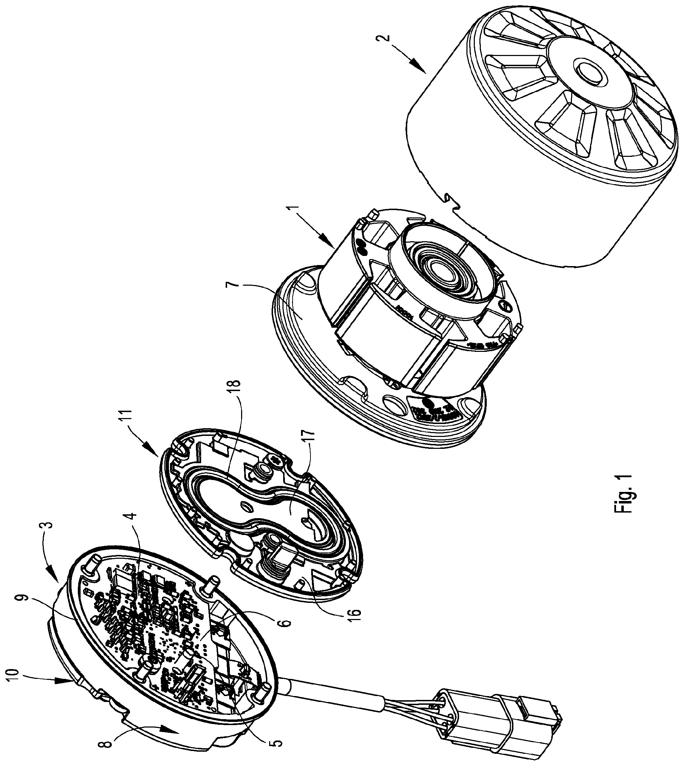

In den Fig. 1 bis 7 sind gleiche Teile bzw. funktionsgleiche Teil mit denselben Bezugszeichen gekennzeichnet. Sofern bestimmte beschriebene und/oder aus den Zeichnungen entnehmbare Merkmale des erfindungsgemäßen Gehäuses bzw. Volumenausgleichselementes oder ihrer Bestandteile nur im Zusammenhang mit einem Ausführungsbeispiel beschrieben sind, sind diese aber auch gemäß der Erfindung unabhängig von diesem Ausführungsbeispiel als Einzelmerkmal oder aber auch in Kombination mit anderen Merkmalen des Ausführungsbeispiels wesentlich und werden als zur Erfindung gehörig beansprucht.

Fig. 1 zeigt eine perspektivische Explosionsansicht eines Elektromotors, bestehend aus einem Stator 1 und einem Rotor 2 sowie aus einem Elektronikgehäuse 3, in dem eine elektronische Schaltung 4 aus Bauelementen 5 und einer Leiterplatte 6 angeordnet ist. Das Elektronikgehäuse 3 wird von einer Trägerplatte 7 und einem Gehäusedeckel 8 gebildet. Die Trägerplatte 7 ist im dargestellten Ausführungsbeispiel als Statorflansch des Elektromotors ausgebildet. Der Gehäusedeckel 8 wird von einer umfangsgemäß geschlossenen, auf der Trägerplatte 7 druckdicht aufsetzbaren, Wandung 9 und einem mit der Wandung 9 verbundenen, der Trägerplatte 7 gegenüberliegenden Abdeckteil 10 gebildet und mit der Trägerplatte 7 z. B. verschraubt.

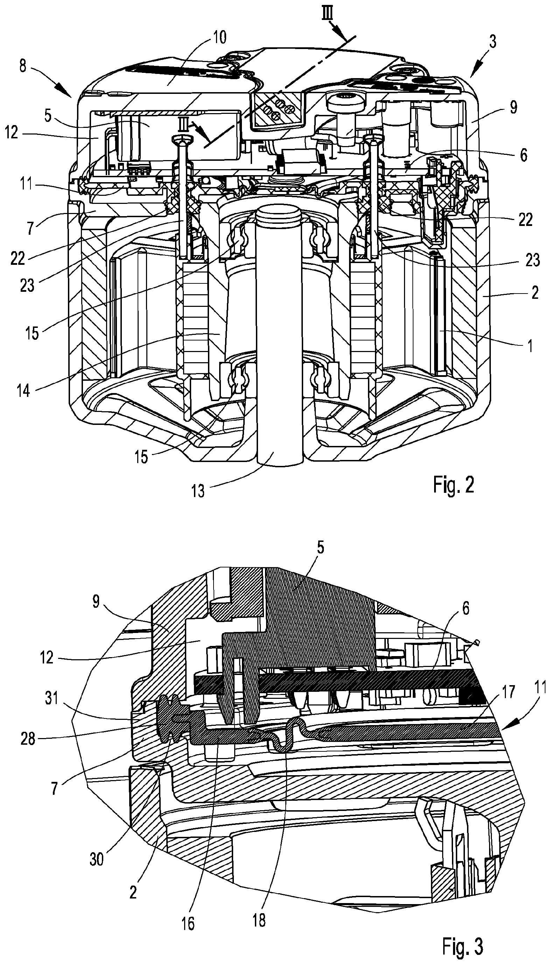

Erfindungsgemäß ist vorgesehen, dass auf der Trägerplatte 7 ein Volumenausgleichselement 11 angeordnet ist, das somit zwischen einem die elektronische Schaltung 4 enthaltenen Innenraum 12 des Gehäusedeckels 8 und der Trägerplatte 7 angeordnet ist und den Innenraum 12 von der Trägerplatte 7 und den mit der Trägerplatte 7 im Übrigen verbundenen Konstruktionsteilen, im vorliegenden Fall dem aus Stator 1 und Rotor 2 bestehenden Elektromotor, trennt. Wie sich insbesondere aus Fig. 2 ergibt, wird das Volumenausgleichselement 11 mittels der Wandung 9 im aufgesetzten Zustand des Gehäusedeckels 8 auf der Trägerplatte 7, dem Statorflansch, befestigt und es wird eine umfangsgemäße Abdichtung eines innerhalb des Gehäusedeckels 8 befindlichen Innenraums 12 gegenüber der das Elektronikgehäuse 3 eingebundenen Atmosphäre (Umgebung) bewirkt.

Der dargestellte Elektromotor ist als Außenläufermotor ausgebildet, so dass der glockenförmig ausgebildete Rotor 2 den Stator 1 umfangsgemäß einschließt. Der Rotor 2 ist über eine Welle 13 innerhalb eines Lagertragrohres 14, das an der als Statorflansch ausgebildeten Trägerplatte 7 ausgebildet ist, über Lagerelemente 15 gelagert. Hierzu wird auf Fig. 2 verwiesen. Ein derartiger Elektromotor entspricht dem Stand der Technik.

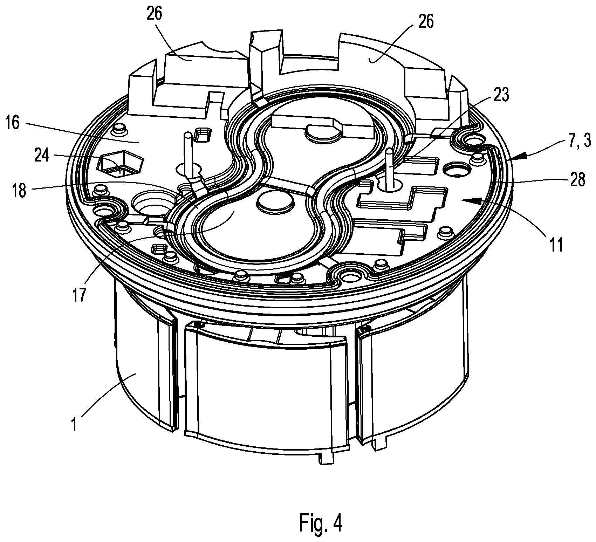

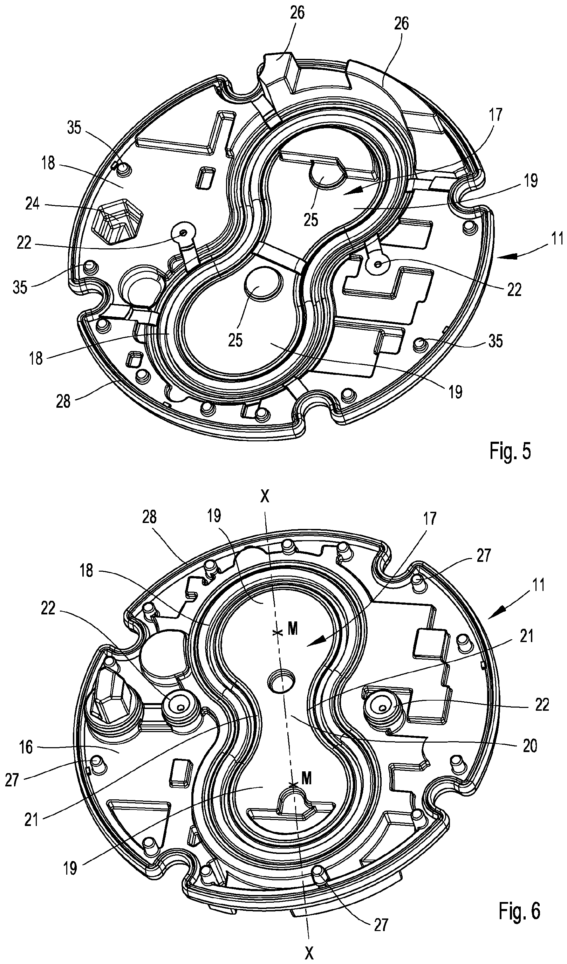

Wie aus Fig. 4 zu ersehen ist, wird auf die Trägerplatte 7 das Volumenausgleichselement 11 aufgelegt. Das Volumenausgleichselement 11 besteht, wie in den Fig. 5 und 6 dargestellt ist, aus einem äußeren, umfangsgemäß geschlossenen Befestigungsabschnitt 16 und einem mittleren, gegenüber dem Befestigungsabschnitt lageveränderbaren Membranabschnitt 17. Der Membranabschnitt 17 ist mit dem Befestigungsabschnitt 16 über einen federelastisch verformbaren, umfangsgemäß geschlossenen Verbindungsabschnitt 18 verbunden. Der Befestigungsabschnitt 16 und der Membranabschnitt 17 bestehen aus einem härteren Material als das Material des Verbindungsabschnittes 18. Der Verbindungsabschnitt 18 besteht vorzugsweise aus einem thermoplastischen Elastomer mit einer Shore-A-Härte von 30 bis 60, vorzugsweise 35. Als Material für die Herstellung des Befestigungsabschnittes 16 und des Membranabschnittes 17 wird vorzugsweise ein Polypropylen, z. B. PPH verwendet. Die Dicke des Befestigungsabschnittes 16 und des Membranabschnittes 17 ist klein gegenüber deren Breite bzw. Längserstreckung, so dass das Volumenausgleichselement 11 scheibenförmig und vorteilhafterweise 2 bis 4 mm dick ist und somit der Membranabschnitt 17 eine geringe Masse besitzt. Durch die federelastische Ausbildung des Verbindungsabschnittes 18 kann der Membranabschnitt 17 sich in Bezug auf den Befestigungsabschnitt 16 bewegen, wenn auf den Membranabschnitt 17 beispielsweise vertikale Kräfte einwirken. Bei einer vertikalen Kraftbeaufschlagung erfolgt praktisch eine Parallel-Verschiebung des Membranabschnitts 17 in Bezug auf den Befestigungsabschnitt 16. Sobald eine derartige Krafteinwirkung nicht mehr vorhanden ist, federt der Membranabschnitt 17 in seine Ausgangslage zurück, in der er sich in derselben Ebene befindet, wie der Befestigungsabschnitt 16. Das Volumenausgleichselement 11 ist im Bereich seines Befestigungsabschnittes 16 derart an seiner Auflagefläche ausgebildet, dass der Befestigungsabschnitt 16 auf der Trägerplatte 7 in einer parallelen Ebene zur Trägerplatte 7 und kippfrei umfangsgemäß aufliegt. Im dargestellten Ausführungsbeispiel ist der Membranabschnitt 17 derart ausgebildet, dass er aus zwei Hauptabschnitten 19 mit einer kreisförmigen Umrisskontur besteht, die über einen Abstandsabschnitt 20 miteinander verbunden sind. Die beiden Hauptabschnitte 19 haben die gleiche Größe und der Abstandsabschnitt 20 weist konkav gekrümmte Längskanten 21 auf, wobei der Membranabschnitt 17 spiegelsymmetrisch zu einer Verbindungsgraden X-X durch die Mittelpunkte M der kreisförmigen Hauptabschnitte 19 ausgebildet ist.

Das Volumenausgleichselement 11 ist vorzugsweise als Mehr-Komponenten-Kunststoffspritzgussteil ausgebildet. Wie weiter zu erkennen ist, besitzt das Volumenausgleichselement 11 im Befestigungsabschnitt 16 druckdicht gegenüber einer äußeren Atmosphäre abgedichtete Durchführungen 22 für Kontaktstifte 23, wobei es sich im dargestellten Ausführungsbeispiel um Stifte für die Durchführung der Wicklungsanschlüsse von einer im Elektromotor befindlichen Motorwicklung zu der elektronischen Schaltung 4 handelt. Weiterhin weist der Befestigungsabschnitt 16 beispielsweise mindestens eine zum Innenraum des Elektronikgehäuses 3 offene Aufnahmetasche 24 auf. Hierbei kann beispielsweise die Aufnahmetasche 24 zur Aufnahme eines Hall-ICs dienen, mit dem die Drehstellung des Elektromotors detektiert wird. Weiterhin besitzt das erfindungsgemäße Volumenausgleichselement 11 in seinem umfänglichen Randbereich einen Dichtungsabschnitt 28 zum druckdichten Befestigen gegenüber der äußeren Atmosphäre des Volumenausgleichselementes 11 zwischen der Wandung 9 und der Trägerplatte 7, siehe Fig. 3. Hierdurch entsteht ein gegen die äußere Atmosphäre bzw. Umgebung abgedichteter Innenraum 12 des Gehäusedeckels 8. Durch diese Abdichtung kann in diesen von außen keine Feuchtigkeit eindringen, wodurch die elektronischen Bauelemente 5 der elektronischen Schaltung 4 gegen äußere Feuchtigkeit geschützt sind. Auf Grund dieser druckdichten Ausführung des erfindungsgemäßen Gehäuses ist es erforderlich, einen Druckausgleich vorzusehen, um Druckschwankungen im Gehäuse, d. h. dem Innenraum 12 auf Grund von Erwärmung oder Erkaltung ausgleichen zu können. Dies gewährleistet das erfindungsgemäße Volumenausgleichselement 11, denn bei einer Erhöhung des Innendrucks durch Temperaturanstieg im Innenraum 12 des Elektronikgehäuses 3 erfolgt eine Lageverschiebung des Membranabschnittes 17 in Richtung auf die Trägerplatte 7, wodurch das Innenraumvolumen vergrößert und somit eine Druckerhöhung abgebaut wird. Bei einer Verringerung der Temperatur im Innenraum 12 verringert sich ebenfalls der dort herrschende Druck, so dass der Membranabschnitt 17 in Richtung auf die elektronische Schaltung 4 sich bewegt, so dass das Innenraumvolumen verkleinert und ein Druckausgleich bewirkt wird. Durch das erfindungsgemäße Volumenausgleichselement 11 wird somit einerseits ein Feuchtigkeitsschutz der elektronischen Bauelemente gewährleistet, da keine Feuchtigkeit eindringen kann, und andererseits wird ein notwendiger Druckausgleich innerhalb des Elektronikgehäuses bewirkt. Dabei erfolgt dieser Druckausgleich in Form eines Volumenausgleichs und nicht durch einen Massenausgleich, wie beispielsweise bei der Verwendung bekannter Druckausgleichsmembranen im Elektronikgehäuse. Bei einer Temperatur von z. B. 20 ° C im Innenraum 12 des Gehäuses nimmt der Membranabschnitt 17 auf Grund der federelastischen Ausbildung des Verbindungsabschnittes 18 seine Ausgangslage ein, in der er in derselben Ebene verläuft, wie der Befestigungsabschnitt 16. Gemäß der Erfindung kann es zweckmäßig sein, wenn auf der der Leiterplatte 6 zugekehrten Seite des Membranabschnitts 17 ein oder mehrere Ansätze 25 ausgebildet sind, die als Anschlagkörper zum Begrenzen der Bewegung des Membranabschnittes 17 dienen. Zweckmäßigerweise ist erfindungsgemäß vorgesehen, dass im Innenraum 12 ein möglichst geringes Luftvolumen vorhanden ist. Dies wird einerseits dadurch erreicht, dass die Abmessungen des Elektronikgehäuses 3 derart gewählt sind, dass die elektronische Schaltung 4 mit geringen Abständen zu dem Gehäusedeckel 8 und der Wandung 9 und dem Volumenausgleichselement 11 angeordnet ist. Darüber hinaus kann es erfindungsgemäß zweckmäßig sein, wenn auf dem Befestigungsabschnitt 16 des Volumenausgleichselements 11 in den Innenraum 12 ragende Volumenelemente 26 angeordnet sind, die in die Freiräume zwischen den elektronischen Bauelementen 5 der Wandung 9 hineinragen, so dass das Luftvolumen innerhalb des Innenraums 12 reduziert wird.

Wie aus Fig. 6 zu erkennen ist, befinden sich auf der Rückseite des Volumenausgleichselements 11 im Bereich seines Befestigungsabschnittes 16, d. h. auf der der Trägerplatte 7 zugekehrten Seite, Abstützdome 27, mit denen das Volumenausgleichselement 11 auf der Trägerplatte 7 aufliegt, wobei das Volumenausgleichselement 11 in einer zur Trägerplatte 7 parallelen Ebene liegt. Die Abstützdome 27 befinden sich zweckmäßigerweise in der Nähe des Außenrandes des Volumenausgleichelementes 11. Die Anzahl und Anordnung der Abstützdome 27 ist derart, dass eine voll umfängliche sichere Auflage auf der Trägerplatte 7 sichergestellt ist. Weiterhin ist zu erkennen, dass das Volumenausgleichselement 11 den an seinem Außenrand umlaufenden Dichtungsabschnitt 28 besitzt, der aus einer elastischen Dichtung besteht, die aus bekanntem gummielastischem Dichtmaterial besteht, der an den Befestigungsabschnitt 16 angespritzt sein kann. Dieser Dichtungsabschnitt 28 ist als Profildichtung ausgebildet und liegt im auf der Trägerplatte 7 angeordneten Zustand auf einem umlaufenden Auflageansatz 30 der Trägerplatte 7 in deren Randbereich, wobei der Auflageansatz 30 gegenüber einer Oberkante eines die Trägerplatte 7 umgebenden Radsteges 31 nach innen in Richtung auf eine Bodenfläche 32 der Trägerplatte 7 versetzt ist. Im montierten Zustand des Elektronikgehäuses 3, wie in Fig. 2 dargestellt, liegt die Wandung 9 des Gehäusedeckels 8 gegen die umlaufende Profildichtung 28 des Volumenausgleichselements 11 an und verpresst dieses, so dass eine gegen die äußere Umgebung druckdichte Abdichtung des Innenraums 12 erfolgt.

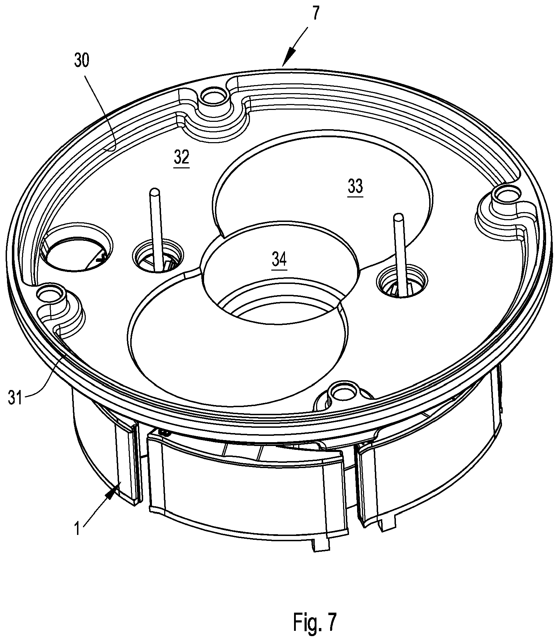

In der Bodenfläche 32 ist eine Vertiefung 33 ausgebildet, siehe Fig. 7, die derart geformt ist, dass sie den Membranabschnitt 17 im ausgelenkten Zustand aufnehmen kann. In der Vertiefung 33 befindet sich eine Öffnung 34, die sich durch die im Lagertragrohr 14 ausgebildete Bohrung ergibt und über die ein zwischen dem Volumenausgleichselement 11 und der Trägerplatte 7 befindlicher Zwischenraum z. B. mit der Atmosphäre bzw. Umgebung verbunden ist.

Auf seiner der Leiterplatte 6 zugekehrten Oberseite weist der Befestigungsabschnitt Stützelemente 35 auf, die gegenüber der Oberseite vorstehen. Auf den Stützelementen 35 kann sich die Leiterplatte 6 abstützen, so dass die Höhe der Stützelemente 35 den Mindestabstand zum Volumenausgleichselement 11 bestimmt.

Durch die Erfindung wird erreicht, dass im Innenraum 12 eine im Vergleich zum Gesamtvolumen des Innenraums 12 nur minimales Luftvolumen vorhanden ist, so dass auch nur eine minimale Menge an Feuchtigkeit in diesem Luftvolumen eingeschlossen sein kann. Hierdurch wird eine Schädigung der elektronischen Bauelemente 5 auf Grund von Feuchtigkeit weitgehend vermieden. Durch den Druckausgleich mittels des Volumenausgleichselements 11 und den dadurch bewirkten Volumenausgleich kann keine weitere Feuchtigkeit durch einen Stoffstrom über die Gehäusedichtung eindringen, wodurch es nicht zur Akkumulation von Feuchtigkeit kommen kann, da kein Massentransport in das Elektronikgehäuse auf Grund eines Druckgefälles zwischen der Umgebung und dem Innenraum erfolgt. Zudem ist die Elektronik vollständig gegen die Umgebung abgedichtet, was durch das Dichtelement 28 am Rande des erfindungsgemäßen Volumenausgleichselements 11 erreicht wird. An Stelle eines angespritzten Dichtelementes aus einem dichtenden Kunststoffwerkstoff kann aber auch ein üblicher O-Dicht-Ring zur Abdichtung verwendet werden.

Die vorliegende Erfindung ist an Hand eines Elektromotors mit seinen spezifischen Bauteilen erläutert. Jedoch ist die Erfindung nicht auf diese Anwendung beschränkt, sondern ist auch generell für jede Form von Gehäusen geeignet, in denen elektronische Bauteile feuchtigkeitsgeschützt untergebracht werden.

Die Erfindung ist nicht auf die dargestellten und beschriebenen Ausführungsbeispiele beschränkt, sondern umfasst auch alle im Sinne der Erfindung gleichwirkenden Ausführungen. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des Anspruchs 1 weggelassen bzw. durch mindestens ein an anderer Stelle der Anmeldung offenbartes Einzelmerkmal ersetzt werden kann. Insofern ist der Anspruch 1 lediglich als ein erster Formulierungsversuch für eine Erfindung zu verstehen.

## Patentansprüche

1. Gehäuse zur Aufnahme einer Elektronikschaltung (4) aus mehreren Bauelementen (5), bestehend aus einer Trägerplatte (7) und einem Gehäusedeckel (8) mit einer auf der Trägerplatte (7) angeordneten umfangsgemäß geschlossenen Wandung (9) und einem auf der Wandung (9) angeordneten, der Trägerplatte (7) gegenüberliegenden Abdeckteil (10), **dadurch gekennzeichnet,**
**dass** auf der Trägerplatte (7) in einem vom Gehäusedeckel (8) gegenüber einer äußeren Atmosphäre druckdicht umschlossenen Innenraum (12) ein Volumenausgleichselement (11) befestigt und derart elastisch ausgebildet ist, dass zum Ausgleich von im Innenraum (12) auftretenden Druckschwankungen ein veränderliches Raumvolumen durch eine Lageveränderung des Volumenausgleichselements (11) in Bezug auf die Trägerplatte (7) vorhanden ist sowie ein Zwischenraum zwischen dem Volumenausgleichselement (11) und der Trägerplatte (7) mit der äußeren Atmosphäre verbunden ist, wobei das Volumenausgleichselement (11) aus einem äußeren Befestigungsabschnitt (16) und einem inneren Membranabschnitt (17) besteht, die über ein federelastisches Verbindungsteil (18) umfänglich miteinander verbunden sind und wobei der Befestigungsabschnitt (16) auf seiner der elektronischen Schaltung (4) zugekehrten Seite Volumenelemente (26) aufweist, die in Zwischenräume zwischen den elektronischen Bauelementen (5) und zu der Wandung (9) hineinragen und zur Verkleinerung des im Innenraum (12) vorhandenen Luftvolumens dienen.

2. Gehäuse nach Anspruch 1,
**dadurch gekennzeichnet, dass** das Volumenausgleichselement (11) aus einem Kunststoffformteil gebildet ist, das einen äußeren umfangsgemäß geschlossenen Befestigungsabschnitt (16) und einen mittleren, gegenüber dem Befestigungsabschnitt (16) lageveränderbaren Membranabschnitt (17) aufweist, und der Membranabschnitt (17) und der Befestigungsabschnitt (16) über einen federelastisch verformbaren umfangsgemäß geschlossenen Verbindungsabschnitt (18) verbunden sind.

3. Gehäuse nach Anspruch 1 oder 2,
**dadurch gekennzeichnet, dass** das Volumenausgleichselement (11) als Mehr-Komponenten-Kunststoffspritzgussteil ausgebildet ist.

4. Gehäuse nach Anspruch 2 oder 3,
**dadurch gekennzeichnet, dass** im Befestigungsabschnitt (16) abgedichtete Durchführungen für Kontaktstifte oder dergleichen ausgebildet sind.

5. Gehäuse nach einem der Ansprüche 2 bis 4,
**dadurch gekennzeichnet, dass** im Befestigungsabschnitt (16) zum Innenraum (12) offene Aufnahmetaschen (24) für elektronische Bauteile ausgebildet sind.

6. Gehäuse nach einem der Ansprüche 2 bis 5,
**dadurch gekennzeichnet, dass** der Befestigungsabschnitt (16) in seinem umfänglichen Randbereich ein Dichtprofil (28) zum druckdichten Befestigen zwischen der Wandung (9) und der Trägerplatte (7) aufweist.

7. Gehäuse nach einem der Ansprüche 2 bis 6,
**dadurch gekennzeichnet, dass** der Befestigungsabschnitt (16) derart ausgebildet ist, dass eine parallele Lage zur Trägerplatte (7) gegeben ist und er vorzugsweise Abstützdome (27) zur Auflage aufweist.

8. Gehäuse nach einem der Ansprüche 2 bis 7,
**dadurch gekennzeichnet, dass** der Membranabschnitt (17) auf seiner der Elektronikschaltung (4) zugekehrten Seite auf seiner Oberfläche mindestens einen hubbegrenzenden Ansatz (25) aufweist.

9. Gehäuse nach einem der Ansprüche 3 bis 8,
**dadurch gekennzeichnet, dass** der Membranabschnitt (17) zwei Hauptabschnitte (19) mit einer kreisförmigen Umrisskontur aufweist, die über einen Abstandsabschnitt (20) miteinander verbunden sind, dessen Längskanten (21) voneinander beabstandet und konkav gekrümmt sind und der Membranabschnitt (17) spiegelsymmetrisch zu einer Verbindungsgraden (X-X) durch die Mittelpunkte (M) der kreisförmigen Hauptabschnitte (19) ausgebildet ist.

10. Gehäuse nach einem der Ansprüche 2 bis 9,
**dadurch gekennzeichnet, dass** die Trägerplatte (7) im Bereich unterhalb des Membranabschnitts (17) eine Vertiefung (32) aufweist, deren Form und Größe derart ist, dass der Membranabschnitt (17) in der Vertiefung (32) aufgenommen werden kann.

11. Gehäuse nach einem der Ansprüche 1 bis 10,
**dadurch gekennzeichnet, dass** die elektronische Schaltung (4) auf einer Leiterplatte (6) angeordnet ist, die parallel zum Volumenausgleichselement (11) verläuft und vorzugsweise gegen Stützelemente (35) des Volumenausgleichselementes (11) anliegt.

12. Gehäuse nach einem der Ansprüche 1 bis 11,
**dadurch gekennzeichnet, dass** die Trägerplatte (7) als Statorflansch eines Elektromotors ausgebildet ist.

13. Gehäuse nach Anspruch 12,
**dadurch gekennzeichnet, dass** an dem Statorflansch ein Lagertragrohr (14) ausgebildet ist, und eine im Lagertragrohr befindliche Bohrung über eine Öffnung (34) im Zwischenraum zwischen Volumenausgleichselement (11) und Trägerplatte (7) mündet.

## Claims

1. A housing to accommodate an electronic circuit (4) comprising several components (5), said housing consisting of a carrier plate (7) and a housing cover (8) having a circumferentially closed wall (9) arranged on the carrier plate (7) and having a cover part (10) arranged on the wall (9) opposite from the carrier plate (7), **characterized in that**
a volume-equalizing element (11) is fastened to the carrier plate (7) in an inner chamber (12) which is enclosed by the housing cover (8) so as to be pressure-tight vis-à-vis the outside atmosphere and which is configured elastically in such a way that, for purposes of equalizing pressure fluctuations that occur in the inner chamber (12), a variable volume is created by a change in the position of the volume-equalizing element (11) relative to the carrier plate (7), and moreover, an intermediate space between the volume-equalizing element (11) and the carrier plate (7) is connected to the outside atmosphere, whereby the volume-equalizing element (11) consists of an outer fastening section (16) and an inner membrane section (17) that are connected to each other circumferentially by means of a resilient connecting part (18), and whereby the side of the fastening section (16) facing the electronic circuit (4) has volume elements (26) which project into intermediate spaces between the electronic components (5) and the wall (9) and which serve to reduce the air volume present in the inner chamber (12).

2. The housing according to claim 1, **characterized in that** the volume-equalizing element (11) is made up of a plastic molded part that has an outer circumferentially closed fastening section (16) and a center membrane section (17) whose position can be changed relative to the fastening section (16), and the membrane section (17) and the fastening section (16) are connected by means of a circumferentially closed connecting section (18) that can be resiliently deformed.

3. The housing according to claim 1 or 2, **characterized in that** the volume-equalizing element (11) is configured as a multi-component plastic injection-molded part.

4. The housing according to claim 2 or 3, **characterized in that** sealed-off conduits for contact pins or the like are configured in the fastening section (16).

5. The housing according to one of claims 2 to 4, **characterized in that** holding pockets (24) that are open towards the inner chamber (12) and that serve to accommodate electronic components are configured in the fastening section (16).

6. The housing according to one of claims 2 to 5, **characterized in that** the circumferential edge area of the fastening section (16) has a sealing profile (28) to be fastened pressure-tight between the wall (9) and the carrier plate (7).

7. The housing according to one of claims 2 to 6, **characterized in that** the fastening section (16) is configured in such a way as to yield a parallel position relative to the carrier plate (7), and the fastening section (16) preferably has support studs (27) for placement purposes.

8. The housing according to one of claims 2 to 7, **characterized in that** the surface of the membrane section (17) has at least one stroke-limiting projection (25) on the side facing the electronic circuit (4).

9. The housing according to one of claims 3 to 8, **characterized in that** the membrane section (17) has two main sections (19) which have a circular outer contour and which are connected to each other via a spacer section (20) whose longitudinal edges (21) are at a distance from each other and are curved concavely, and the membrane section (17) is configured so as to be mirror-symmetrical to a connecting straight line (X-X) through the mid-point (M) of the circular main sections (19).

10. The housing according to one of claims 2 to 9, **characterized in that**, in the area below the membrane section (17), the carrier plate (7) has a depression (32) whose shape and size are such that the membrane section (17) can be accommodated in the depression (32).

11. The housing according to one of claims 1 to 10, **characterized in that** the electronic circuit (4) is arranged on a printed circuit board (6) that runs parallel to the volume-equalizing element (11) and that preferably rests against support elements (35) of the volume-equalizing element (11).

12. The housing according to one of claims 1 to 11, **characterized in that** the carrier plate (7) is configured as a stator flange of an electric motor.

13. The housing according to claim 12, **characterized in that** a bearing-support tube (14) is configured on the stator flange and a hole drilled in the bearing-support tube opens up through an opening (34) into the intermediate space between the volume-equalizing element (11) and the carrier plate (17).

## Revendications

1. Boîtier destiné à recevoir une circuiterie électronique (4) composée de plusieurs composants (5), composé d'une plaque de support (7) et d'un couvercle de boîtier (8) avec une paroi (9) fermée sur le pourtour et agencée sur la plaque de support (7) et une pièce de recouvrement (10) située sur la (9) vis-à-vis de la plaque de support (7),
**caractérisé en ce que**
un élément de compensation de pression (11) est fixé sur la plaque de support (7) dans un espace intérieur (12) entouré par le couvercle de boîtier (8) de manière étanche à la pression par rapport à une atmosphère extérieure, et est réalisé élastiquement de sorte que,
pour compenser des variations de pression se présentant dans l'espace intérieur (12), il y a un volume variable du fait d'une modification de position de l'élément de compensation de volumes (11) par rapport à la plaque de support (7) et
un espace intermédiaire entre l'élément de compensation de volume (11) et la plaque de support (7) est relié à l'atmosphère extérieure, l'élément de compensation de volume (11) étant composé d'une partie de fixation extérieure (16) et d'une partie formant membrane intérieure (17), lesquelles sont reliées entre elles sur le pourtour par une pièce de liaison élastique (18), et la partie de fixation (16) comportant, sur son côté en regard de la circuiterie électronique (4), des éléments de volume (26) qui font saillie dans des espaces intermédiaires entre les composants électroniques (5) et la paroi (9) et qui servent à réduire le volume d'air contenu dans l'espace intérieur (12).

2. Boîtier selon la revendication 1,
**caractérisé en ce que** l'élément de compensation de volume (11) est formé par une pièce moulée en matière plastique qui comporte une partie de fixation extérieure (16) fermée sur son pourtour et une partie formant membrane centrale (17) à position variable vis-à-vis de la partie de fixation (16) et **en ce que** la partie formant membrane (17) et la partie de fixation (16) sont reliées par une partie de liaison (18) fermée sur son pourtour et déformable élastiquement.

3. Boîtier selon la revendication 1 ou 2,
**caractérisé en ce que** l'élément de compensation de volume (11) est réalisé en tant que pièce moulée par injection de matière plastique composite.

4. Boîtier selon la revendication 2 ou 3,
**caractérisé en ce que** sont réalisées, dans la partie de fixation (16), des traversées étanches pour des tiges de contact ou autres similaires.

5. Boîtier selon l'une des revendications 2 à 4,
**caractérisé en ce que** sont réalisées, dans la partie de fixation (16), des poches de logement (24) pour composants électroniques ouvertes sur l'espace intérieur (12).

6. Boîtier selon l'une des revendications 2 à 5,
**caractérisé en ce que** la partie de fixation (16) comporte, dans sa zone de bord périphérique, un profilé d'étanchéité (28) pour fixation étanche à la pression entre la paroi (9) et la plaque de support (7).

7. Boîtier selon l'une des revendications 2 à 6,
**caractérisé en ce que** la partie de fixation (16) est réalisée de manière à avoir une position parallèle à la plaque de support (7) et à présenter préférentiellement des dôme de support (27) pour prise appui.

8. Boîtier selon l'une des revendications 2 à 7,
**caractérisé en ce que** la partie formant membrane (17) présente, sur son côté en regard de la circuiterie électronique (4), sur sa surface, au moins une saillie (25) de limitation de course.

9. Boîtier selon l'une des revendications 3 à 8,
**caractérisé en ce que** la partie formant membrane (17) comporte deux parties principales (19) présentant un contour circulaire et reliées entre elles par une partie d'espacement (20) dont les bords longitudinaux (21) sont espacés l'un de l'autre et présentent une courbure concave et **en ce que** la partie formant membrane (17) est réalisée symétriquement en image miroir par rapport à une droite de liaison (X-X) passant par les points centraux (M) des parties principales circulaires (19).

10. Boîtier selon l'une des revendications 2 à 9,
**caractérisé en ce que** la plaque de support (7) présente, dans la zone située en dessous de la partie formant membrane (17), un creux (32) dont la forme et la taille sont telles que la partie formant membrane (17) peut être logée dans le creux (32).

11. Boîtier selon l'une des revendications 1 à 10,
**caractérisé en ce que** la circuiterie électronique (4) est agencée sur une carte de circuit imprimé (6) qui est parallèle à l'élément de compensation de volume (11) et prend préférentiellement appui sur des éléments d'appui (35) de l'élément de compensation de volume (11).

12. Boîtier selon l'une des revendications 1 à 11,
**caractérisé en ce que** la plaque de support (7) est réalisée en tant que flasque de stator d'un moteur électrique.

13. Boîtier selon la revendication 12,
**caractérisé en ce qu'**un tube porteur de palier (14) est réalisé sur le flasque de stator et **en ce qu'**un perçage situé dans le tube porteur de palier débouche, via une ouverture (34), dans l'espace intermédiaire entre l'élément de compensation de volume (11) et la plaque de support (7).
